(19) Europäisches Patentamt

European Patent Office

Office européen des brevets

(11) **EP 0 903 852 B1**

(12) **EUROPÄISCHE PATENTSCHRIFT**

(45) Veröffentlichungstag und Bekanntmachung des Hinweises auf die Patenterteilung:
**18.02.2004 Patentblatt 2004/08**

(51) Int Cl.$^7$: **H03J 1/00**

(21) Anmeldenummer: **98116588.9**

(22) Anmeldetag: **02.09.1998**

(54) **Verfahren zum Abgleich eines mehrstufigen selektiven Verstärkers**

Aligning method for a multistage selective amplifier

Procédé d'accord d'un amplificateur sélectif à plusieurs étages

(84) Benannte Vertragsstaaten:
**DE FR GB IT**

(30) Priorität: **19.09.1997 DE 19741325**

(43) Veröffentlichungstag der Anmeldung:
**24.03.1999 Patentblatt 1999/12**

(73) Patentinhaber:
• **ATMEL Germany GmbH**
  **74072 Heilbronn (DE)**
• **BECKER GmbH**
  **D-76307 Karlsbad (DE)**

(72) Erfinder:
• **Becker, Karl Anton**
  **76307 Karlsbad (DE)**
• **Brinkhaus, Stefan**
  **75196 Remchingen (DE)**
• **Ganz, Armin**
  **76467 Bietigheim (DE)**
• **Memmler, Bernd**
  **74538 Rosengarten (DE)**
• **Kröbel, Hans-Eberhardt**
  **74080 Heilbronn (DE)**

(56) Entgegenhaltungen:
**EP-A- 0 601 743        EP-A- 0 624 949**
**EP-A- 0 766 391        US-A- 5 428 829**

**Beschreibung**

Die Erfindung betrifft ein Verfahren zum Abgleich eines mehrstufigen selektiven Verstärkers, gemäß dem Oberbegriff des Patentanspruches 1.

Ein derartiges Verfahrens ist aus der Druckschrift EP 0 601 743 A bekannt. Hierbei werden die Abstimmspannungen zur Einstellung der jeweiligen Frequenzen des Oszillatorkreises und der Eingangskreise mittels mehrerer DACs eingestellt, indem sowohl dem Oszillator als auch den jeweiligen Eingangskreisen ein separater DAC zugeordnet ist. Die Abgleichsparameter zur Einstellung der DACs werden für jede einzustellende Frequenz mittels eines Prozessors und den in einem Speicher für jeden Eingangskreis abgelegten charakteristischen Parameter errechnet. Nachteilig hierbei ist, dass zur Einstellung für jede Frequenz durch den Prozessor ein hoher Rechenaufwand und ein Austausch von großen Datenmengen erforderlich ist.

Mit Tunern können verschiedene Programme oder allgemeiner Signale auf unterschiedlichen Frequenzen empfangen, verstärkt und wiedergegeben werden. Abstimmschaltungen werden zur Einstellung der gewünschten Frequenz benötigt. Die den Empfang eines bestimmten Signals, welches auf dieser Frequenz übertragen wird, gewährleisten. Hierbei wird an einem Oszillatorkreis eine Oszillatorfrequenz eingestellt, die um eine Zwischenfrequenz zur gewünschten Empfangsfrequenz verschoben ist und einem Mischer zugeführt wird. Aus der Oszillatorfrequenz und dem vorgefilterten Empfangssignal, das gleichfalls dem Mischer zugeführt ist, wird die feste Zwischenfrequenz gebildet.

Vor dem Mischer befinden sich daher die Vor-, Drain- bzw. Zwischenkreise, die als Frequenzfilter für die Empfangsfrequenz dienen. Hierbei dient die Abstimmschaltung dazu, daß Vor-, Drain- Bzw. Zwischenkreise auf die gewünschte Empfangsfrequenz, der Oszillatorkreis auf die um die ZF-Frequenz versetzte entsprechende Oszillatorfrequenz abgestimmt wird. Sind alle Kreise auf die Sollfrequenz abgestimmt, so wird dies als Gleichlauf bezeichnet, mit dem optimaler Empfang gewährleistet ist.

Aus der EP 0 044 237 A1 ist die Abstimmung eines elektronischen Schaltkreises, insbesondere eines Fernsehempfängers, mit mehreren variablen Elementen und die Regelung der Oszillatorfrequenz über einen Phasenregelkreis bekannt. Dieses Dokument erwähnt insbesondere die Abstimmung eines Filters oder Oszillators mit Kapazitätsdioden. Die bekannte Abgleichvorrichtung enthält einen bereits zum Zeitpunkt der Herstellung fest programmierten Speicher (PROM). Er beinhaltet die Kennlinienfunktion mit der der gewünschte Wert berechnet werden kann. Die abgespeicherten Informationen dienen der Erzeugung von Steuersignalen für die elektronische Abstimmung.

**Nachteilig** hierbei ist jedoch, daß die Kennlinie bereits bei der Herstellung in den Speicher eingegeben wird und etwaige Änderungen, die sich im Laufe der Zeit ergeben, nicht mitberücksichtigt werden können. Auch können mit diesem Verfahren gerätespezifische Abweichungen nicht miteinbezogen werden. Desweiteren ist es bei diesem Verfahren von Bedeutung möglichst viele Punkte der Kennlinie im Speicher abzuspeichern, da die Genauigkeit dieses Verfahrens von der Anzahl der abgespeicherten Kennlinienpunkte abhängig ist. Als weiterer Nachteil ist der rege Datenverkehr beim Frequenzwechsel anzusehen. Bei jedem Frequenzwechsel müssen neue Werte vom Speicher in den Phasenregelkreis geschrieben werden.

Bei bekannten elektronisch abstimmbaren selektiven Verstärkern, insbesondere Tunern, werden in den Vor-, Zwischen- und Oszillatorkreisen meist spannungsgesteuerte Reaktanzelemente (Kapazitätsdioden) zur Abstimmung verwendet. Dort werden den für die Abstimmung verwendeten Kapazitätsdioden getrennte und voneinander unabhängige veränderbare Abstimmspannungen zugeführt. Jeweils nach Wahl eines neuen Kanals wird der Tuner von einem Mikroprozessor mit Hilfe der unabhängig voneinander veränderbaren Abstimmspannungen automatisch auf diesen Kanal abgeglichen. Hierzu trennt zunächst der Mikroprozessor die Antenne vom Eingang des Vorkreises ab und koppelt anstelle dessen einen PLL gesteuerten Oszillator mit der aktuellen Frequenz des betreffenden Kanals ein.

Der Abgleich der einzelnen Kreise erfolgt nacheinander durch Variation der dem jeweiligen Element zugeordneten Abstimmspannung. Über einen am Ausgang des letzten Kreises angeschlossener Detektor wird der Abgleich der einzelnen Kreise beendet, wenn das Maximum der Durchlaßkurve erreicht ist. Nach Beendigung des gesamten Abgleichvorganges wird anstelle des Oszillators wieder die Antenne an den Vorkreis geschaltet. Die so ermittelten Abstimmspannungen werden digital abgelegt bis ein neuer Kanal gewählt wird und der Abgleichvorgang neu abläuft.

Aus der EP 0 147 518 B1 ist es weiterhin bekannt, im Gegensatz zu dem zuvor beschriebenen Verfahren, den Abgleichvorgang über eine anschließbare, externe automatische oder manuelle Abgleichvorrichtung durchzuführen. Diese Abgleichvorrichtungen beinhalten einen externen Zwischenspeicher, der die bei dem iterativen Abgleich gewonnenen Abgleichschritten zwischenspeichert und die optimierten Abgleichwerte in einem Verstärker bzw. Tuner zugeordneten, nichtflüchtigen internen Speicher überträgt. Bei der späteren Kanalwahl werden diese gespeicherten Werte dann abgerufen und die einzelnen Abstimmspannungen entsprechend eingestellt. Da dieser interne Speicher erhebliche Datenmengen beinhalten muß, ist auch vorgesehen, nur jeden n-ten Kanal abzugleichen und die dazwischenliegenden Werte zu interpolieren

Der Nachteil der zuvor genannten, bekannten Verfahren liegt zum einen in dem hohen Speicherplatzbedarf, zum anderen in dem bei jedem Frequenzwechsel (Kanalwechsel) notwendigen Datenverkehr, der einen schnellen Suchlaufvorgang oder Frequenzsprung erheblich beeinträchtigt. Dieser schnelle Suchlauf oder Frequenzsprung ist im TV-Bereich weniger bedeutsam, bei derzeitigen Autoradios aber außerordentlich wichtig, um bei sich verschlechternder Empfangsqualität sehr schnell und damit möglichst unhörbar auf einen alternativen Sender gleichen Programminhaltes zu springen, oder in einem kurzfristigen Frequenzsprung verschiedene. Frequenzen auf alternative Sender zu überprüfen. Auch beim Anlegen einer Tabelle der zu empfangenden Programme sind derartige schnelle Frequenzsprünge notwendig.

Aus der Patentschrift DE 25 24 171 C2 ist eine Abstimmschaltung bekannt, die mittels eines Abstimmpotentiometers die Abstimmspannung liefert und bei der zur Erzielung des Gleichlaufs zwischen den einzelnen Abstimmkreisen weitere Trimmpotentiometer vorgesehen sind.

Weiter ist es bekannt, statt des Abstimmpotentiometers eine PLL-Schleife zur Regelung der Oszillatorfrequenz zu verwenden. Die letztere Anordnung hat den Vorteil, daß lediglich der PLL über einen Prozessor die gewünschte Oszillatorfrequenz übermittelt wird und der Gleichlauf zwangsweise über die Stellung der Abgleichpotentiometer definiert ist.

Der Erfindung liegt daher die **Aufgabe** zugrunde ein Verfahren zum Abgleich eines mehrstufigen selektiven Verstärkers aufzuzeigen, das einen Gleichlauf exakt, schnell und zuverlässig einstellt ohne große Datenmengen abzuspeichern oder einen regen Datenverkehr zu beanspruchen.

Diese Aufgabe wird erfindungsgemäß durch die Merkmale im Kennzeichen der Patentansprüche 1 und 2 gelöst. Hierbei wird der Wert der benötigten Abstimmspannung, welche die zur Abstimmung erforderliche Frequenz erzeugt, aus einer mathematischen Beziehung berechnet, wobei die mathematische Beziehung bei der Produktion oder beim ersten Einschalten ders Gerätes ermittelt und abgespeichert wird.

Die mit der Erfindung erzielten **Vorteile** liegen darin, daß keine großen Datenmengen zur Erzielung des Gleichlaufs in einem Speicher abgelegt bzw. abgerufen werden müssen. Dadurch wird die Abstimmgeschwindigkeit gesteigert ohne daß zusätzliche Speicherkapazitäten oder andere Raum einnehmende Vorrichtungen verwendet werden müssen. Die durch dieses Verfahren ermittelten Werte sind immer genau und nahezu unabhängig von Gerätetoleranzen.

Weitere vorteilhafte **Ausbildungen** ergeben sich daraus, daß die Abstimmspannung der Vor-, Drain- bzw Zwischenkreise, jeweils einzeln aus der Oszillatorabstimmung über eine mathematische Beziehung abgeleitet werden, die bei jedem Einschalten aktualisiert wird. Für die weitere Berechnung müssen nur zwei Werte: ein multiplikativer Faktor und ein additiver Koeffizient abgespeichert werden. Weiterhin müssen beim Einschalten des Gerätes nur zwei Werte vom Speicher in den Phasenregelkreis eingelesen werden.

Im folgenden soll die Erfindung anhand von Ausführungsbeispielen im Zusammenhang mit den Zeichnungen dargestellt und erläutert werden.

**Figur 1:**  Prinzip der erfindungsgemäßen Verfahrens

**Figur 2A:**  Erstes Beispiel der Abstimmkurven für Oszillator-, Vor- und Zwischenkreis

**Figur 2B:**  Zweites Beispiel der Abstimmkurven für Oszillator-, Vor- und Zwischenkreis

**Figur 3A:**  Erstes Ablaufdiagramm zur Einstellung des Gleichlaufs

**Figur 3B:**  Zweites Ablaufdiagramm zur Einstellung des Gleichlaufs

**Figur 4:**  Erfindungsgemäße Verfahren gemäß dem zweiten Ablaufdiagramm von Figur 3B

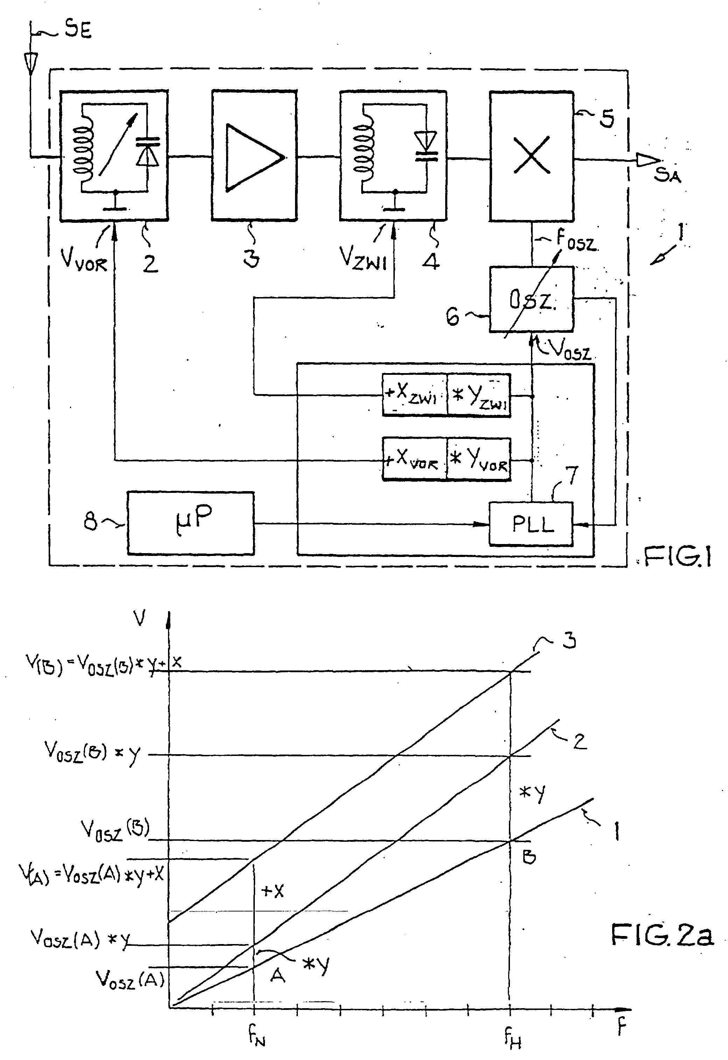

**Figur 1** zeigt das Prinzip der erfindungsgemäßen Abstimmschaltung. Bei dieser Abbildung werden die eingehenden Signale $S_E$ am Vorkreis **2** entsprechend der Empfangsfrequenz gefiltert und dann an einem ersten Verstärker **3** verstärkt. Die hinsichtlich der Empfangsfrequenz des Vorkreises **2** gefilterten und verstärkten Signale gelangen sodann in einen Zwischenkreis **4**, der die Signale nochmals entsprechend der Empfangsfrequenz bzw. Frequenzbereich filtert. Diese verbleibenden Signale werden dann an einen Mischer **5** weitergeleitet, der die verbliebenen Signale exakt auf einer vorgegebenen dritten Frequenz herausfiltert, indem am Oszillatorkreis **6** eine Oszillatorfrequenz eingestellt wird, die die gewünschte Empfangsfrequenz bestimmt. Dann wird das Ausgangssignal $S_A$ an eine Signalverarbeitungseinheit weitergeleitet. Zur Erzielung des Gleichlaufs müssen die Frequenzen oder Frequenzbereiche von Vorkreis **2** und Zwischenkreis **4** mit der Empfangsfrequenz, die durch die Oszillatorfrequenz am Oszillatorkreis **6** bestimmt ist, übereinstimmen oder zumindest beinhalten. Die Einstellung der Oszillatorfrequenz und damit auch der gewünschten Empfangsfrequenz erfolgt über die regulierbare Oszillatorabstimmspannung. Der Oszillatorkreis wird über einen Mikroprozessor **8** angesteuert, der über wird einen Phasenregelkreis **7** die gewünschte Empfangsfrequenz bzw. Oszillatorfrequenz übermittelt. Der Mikroprozessor **8** stellt in der Regelschleife des Oszillator-Phasenregelkreis **7** die entsprechende Oszillatorabstimmspannung $V_{OSZ}$ für den Oszillator **6** ein. Dem Phasenregelkreis **7** sind die entsprechenden Stellglieder für die jeweiligen Abstimmspannungen der zugehörigen weiteren Selektionskreise zugeordnet. In diesem Fall weisen der Vor- und Zwischenkreis **2**, **4** die Abstimmspannungen $V_{VOR}$ und $V_{ZWI}$ auf, die dann diese Kreise auf die mit dem Oszillatorkreis definierte Empfangsfrequenz einstellen. Grundlage hierfür ist eine bestehende feste Relation zwischen der Oszillatorabstimmspannung $V_{OSZ}$ und. der Abstimmspannung des Vorkreises **2** $V_{VOR}$ bzw. der Abstimmspannung des Zwischenkreises **4** $V_{ZWI}$. Diese Relation zwischen den Spannungen ist gekennzeichnet durch einen multiplikativen Koeffizienten **Y** und einem additiven Koeffizienten **X**. Ist die Oszillatorabstimmspannung $V_{OSZ}$ bekannt so gilt:

$$V_{vor} = V_{osz} * Y_{Vor} + X_{Vor} \qquad \text{und} \qquad V_{Zwi} = V_{osz}\ Y_{Zwi} + X_{Zwi}$$

Damit müssen nur die Koeffizienten **Y** und **X** pro Abstimmkreis **2**, **4** zur Realisierung des Gleichlaufs im Gerätespeicher **8** abgelegt werden. Es besteht eine feste Relation zwischen der Oszillatorabstimmspannung $V_{OSZ}$ und der Vorkreisabstimmspannung $V_{VOR}$ bzw. der Zwischenkreisabstimmspannung $V_{ZWI}$. Der additive Koeffizient **X** und der multiplikative Koeffizient **Y** für jeden Kreis **2**, **4** und damit die exakte mathematische Beziehung wird entweder einmal bei der Herstellung des Gerätes oder beim Einschalten des Gerätes ermittelt, wie in Figur 2 beschrieben wird. Dadurch können Bauteilschwankungen oder sogar zeit- und umgebungsabhängige Veränderungen der Gerätes mitberücksichtigt werden.

**Figur 2A** und **Figur 2B** zeigen jeweils ein Beispiel zur Bestimmung der Abstimmkurven. Hierbei zeigt die Kurve **1** in Figur 2A die Beziehung zwischen Oszillatorabstimmspannung $V_{OSZ}$ und der Empfangsfrequenz **f**. Diese Beziehung ist beispielsweise linear. Die Kurve ist dann eine Gerade und kann durch eine lineare Funktionsgleichung beschrieben werden. Die Kurve **2** ergibt sich durch eine Multiplikation der Kurve **1** mit einem Koeffizienten **Y.** Die Kurve **3,** hierbei handelt es sich um die Abstimmkurve des Vor- oder Zwischenkreises ergibt sich aus der Kurve **2** und einer Addition mit einem Koeffizienten **X**. Die für die jeweiligen Abstimmkreis relevanten Koeffzienten **Y** und **X** können einmalig bei der Herstellung oder beim Einschalten des Gerätes ermittelt werden. Diese Werte werden dann in den Speicher des Mikroprozessors eingelesen und von dort in den Phasenregelkreis geladen. Die Bestimmung der Koeffizienten erfolgt dadurch, daß zunächst über den Phasenregelkreis der Oszillator auf den ersten Gleichlaufpunkt **A** bei einer niedrigen Empfangsfrequenz $f_N$ eingestellt wird. Dann wird die entsprechende Empfangsfrequenz **f** über einen Meßsender eingespeist und die Feldstärkespannung im weiteren Zuge des Empfängers wie bekannt gemessen. Über den Mikroprozessor werden die zugehörigen Werte aller **X** und **Y** Stellgrößen im Sinne eines Maximumabgleichs dieser Feldstärkespannung variiert und die sich ergebenden Werte für die Maxima festgehalten. Beim zweiten Gleichlaufpunkt **B** bei einer höheren Empfangsfrequenz $f_H$ wird diese Verfahren wiederholt und die Werte festgehalten und daraus die jeweilige Spannungen **V (A)** und **V (B)** berechnet.

Die Abstimmspannung für den Vorkreis ergibt sich dann für den Punkt **A** zu:

$$V_{Vor}(A) = V_{Osz}(A) * Y_{Vor}(A) + X_{Vor}(A)$$

und für den Punkt B:

$$V_{Vor}(B) = V_{Osz}(B) * Y_{Vor}(B) + X_{Vor}(B)$$

Weiterhin muß gelten:

$$X_{Vor}(A) = X_{Vor}(B) \qquad \text{und} \qquad Y_{Vor}(A) = Y_{Vor}(B)$$

Aus diesen Gleichungen kann dann der Koeffizient **Y** und der additive Koeffizient **X** berechnet werden:

$$Y_{Vor} = \frac{V_{Vor}(B) - V_{Vor}(A)}{Y_{Ost}(B) - V_{Ost}(A)}$$

$$X_{Vor} = V_{Vor}(A) - V_{Ost}(A) * Y_{Vor}$$

Entsprechendes gilt für den Zwischenkreis oder allgemein:

$$Y = \frac{V(B) - V(A)}{V_{Ost}(B) - V_{Ost}(A)}$$

$$X = V(A) - V_{Ost}(A) * Y$$

Damit können diese neuen für beide Abgleichpunkte **A** und **B** geltenden Werte für jeden Selektionskreis berechnet werden und im Speicher abgelegt werden. Diese Werte werden jeweils einmal beim Einschalten des Gerätes in den Phasenregelkreis **7** gemäß Figur 1 eingelesen. Anschließend braucht nur noch die aktuelle, die Empfangsfrequenz **f** erzeugende Oszillatorfrequenz **f**$_{OSZ}$ übertragen zu werden, der Zweipunktgleichlauf ist gesichert. Die für den Abstimmkreise verwendeten Bauelemente bestimmen den Kurvenverlauf. In Figur 2A ist der Abstimmkreis so aufgebaut, daß die Kurve **1** eine Gerade ist. Durch Bestimmung von zwei Punkten auf einer Geraden können alle anderen Punkte daraus berechnet werden. In Figur 2B sind die Abstimmkreise derart aufgebaut, daß die Kurve **1** und damit auch die Kurve **2** und **3** einen logarithmischen Verlauf hat. Hierbei zeigt die Kurve **1** in Figur 2b die Beziehung zwischen Oszillatorabstimmspannung **V**$_{OSZ}$ und der Empfangsfrequenz **f**. Diese Beziehung ist logarithmisch. Die Kurven können durch eine logarithmische Funktionsgleichung beschrieben werden. Die Kurve **2** ergibt sich durch eine Multiplikation der Kurve 1 mit einem Koeffizienten **Y** wie in Figur 2A dargestellt. Die Kurve **3**, hierbei handelt es sich um die Abstimmkurve des Vor- oder Zwischenkreises ergibt sich aus der Kurve **2** und einer Addition mit einem Koeffizienten **X**.

Ist die Funktionsart, also der prinzipielle Verlauf der Funktionskurve, z.B. ein linearer oder logarithmischer Kurvenverlauf, zumindest in einem Teilbereich bekannt, so reichen gleichfalls zwei bekannte Punkte auf dieser Funktionskurve aus um daraus alle Spannungswerte **V** bei einer gegebenen Empfangsfrequenz **f** zumindest für diesen Teilbereich zu berechnen. Die beiden Koeffizienten **Y** und **X** werden entweder bei der Herstellung oder beim Einschalten des Gerätes einmalig oder immer wieder beim Einschalten des Gerätes neu bestimmt. Während der Betriebsdauer des Gerätes sind diese beiden Koeffizienten in einem Speicher fest abgespeichert.

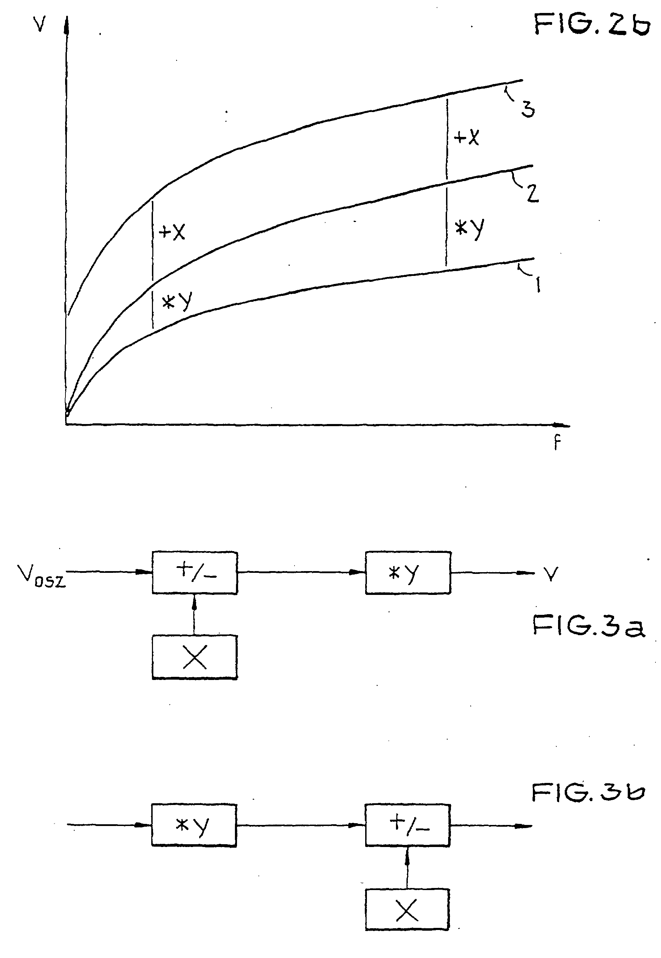

Die Berechnung der jeweiligen Abstimmwerte aus der anliegenden Oszillatorabstimmspannung kann durch die in **Figur 3A** und **3B** dargestellten Ablaufdiagramme erfolgen.

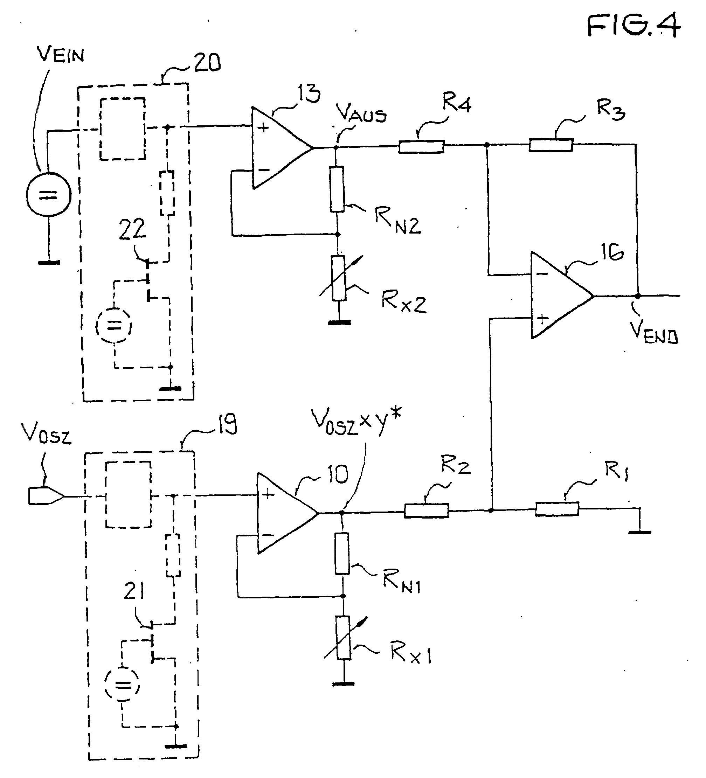

Hierbei zeigt **Figur 3A** die erste Möglichkeit bei der ausgehend von der Oszillatorabstimmspannung **V**$_{OSZ}$ zuerst der additive Koeffizient **X** addiert wird und dann dieser Wert um den Koeffizienten **Y** multiplikativ verstärkt wird. Die zweite Möglichkeit, wie sie in **Figur 3B** dargestellt ist, zeigt ein Ablaufdiagramm bei dem die Oszillatorabstimmspannung **V**$_{OSZ}$ zuerst um einen anderen Koeffizienten **Y** multiplikativ verstärkt wird und dann erst zu diesem Wert der andere additive Koeffizient **X** hinzu addiert wird. Eine Schaltung, die diese Möglichkeit realisiert ist in **Figur 4** dargestellt. Beide Verfahren führen zum gleichen Ergebnis der Abstimmspannung **V** des Vorkreises bzw. Zwischenkreises **V**$_{VOR}$ oder **V**$_{ZWI}$. Koeffizienten **Y** und **X** sind je nach angewendetem Verfahren unterschiedlich.

**Figur 4** zeigt eine erfindungsgemäße Abstimmschaltung. Im wesentlichen wird diese Anordnung von zwei Spannungsquellen gespeist. Zum einen wird die einstellbare, variable Oszillatorabstimmspannung **V**$_{OSZ}$ an den nicht invertierenden Eingang eines ersten Operationsverstärkers **10** angelegt. Alternativ hierzu kann zwischen die Oszillatorabstimmspannung **V**$_{OSZ}$ und dem nicht invertierenden Eingang des Operationsverstärkers **10** ein Vorteiler **19** eingebaut werden. Diese Alternative ist gestrichelt in der Figur eingezeichnet. Der Vorteiler **19** besteht aus zwei Widerständen einem Feldeffekttransistor **21** auch FET genannt und einer Gleichspannungsquelle. Die Gleichspannungsquelle liegt zwischen dem Gate und Source Anschluß des FET **21**. Am Drain Anschluß ist ein Widerstand angeschlossen, welcher einerseits über einen anderen Widerstand mit der Oszillatorabstimmspannung **V**$_{OSZ}$ und andererseits mit dem nicht invertierenden Eingang des ersten Operationsverstärkers **10** verbunden ist. Der invertierende Eingang des ersten Operationsverstärkers **10** ist wie bei einer Verstärkerschaltung üblich mit einem Spannungsteiler verbunden, der Spannungsteiler besteht aus zwei Widerständen **R**$_{N1}$, **R**$_{X1}$. Der eine Widerstand **R**$_{N1}$ ist mit dem Ausgang des Operationsverstärkers **10**, mit dem invertierenden Eingang des Operationsverstärkers **10** und mit dem anderen variablen Widerstand **R**$_{X1}$ welcher einerseits auf Masse und andererseits am invertierenden Eingang des Operationsverstärkers **10** anliegt, verbunden. Dadurch wird die am nicht invertierenden Eingang angelegte Spannung V$_{OSZ}$ verstärkt. Diese verstärkte-Spannung-V$_{OSZ}$•Y*wird über Widerstand R$_2$ an den nicht invertierenden Eingang eines zweiten Operationsverstärkers **16** angelegt. Dieser Widerstand **R$_2$** wiederum ist mit einem anderen Widerstand **R$_1$** verbunden, der gleichfalls an den nicht invertierenden Eingang des zweiten Operationsverstärkers **16** und an Masse angelegt ist.

Zum anderen wird eine feste Eingangsspannung **V**$_{EIN}$ an den nicht invertierenden Eingang eines dritten Operationsverstärkers **13** angelegt. Alternativ hierzu kann zwischen der festen Eingangsspannung **V**$_{EIN}$ und dem nicht invertierenden Eingang ein Vorteiler **20** eingebaut werden. Diese Alternative ist gestrichelt in der Figur eingezeichnet. Der Vorteiler **20** besteht aus zwei Widerständen: einem Feldeffekttransistor **22** auch FET genannt und einer Gleichspannungsquelle Die Gleichspannungsquelle liegt zwischen dem Gate und Source Anschluß des FET **20**. Am Drain Anschluß ist ein Widerstand angeschlossen, welcher einerseits über einen anderen Widerstand mit der festen Eingangsspannung $V_{EIN}$ verbunden ist und andererseits mit dem nicht invertierenden Eingang des dritten Operationsverstärkers **13**. Der invertierende Eingang des dritten Operationsverstärkers **13** ist wie bei einer Verstärkerschaltung üblich mit einem Spannungsteiler verbunden, der Spannungsteiler besteht aus zwei Widerständen $R_{X2}$, $R_{N2}$. Der eine Widerstand $R_{N2}$ ist mit dem Ausgang des dritten Operationsverstärkers **13,** mit dem invertierenden Eingang des dritten Operationsverstärkers **13** und mit dem anderen variablen Widerstand $R_{X2}$, welcher einerseits auf Masse und andererseits am invertierenden Eingang des dritten Operationsverstärkers **13** anliegt, verbunden. Dadurch wird die am nicht invertierenden Eingang angelegte Spannung $V_{EIN}$ verstärkt. Diese Spannung $V_{AUS}$ gelangt über einen Widerstand $R_4$ an den invertierenden Eingang des zweiten Operationsverstärkers **16**. Dieser Widerstand $R_4$ ist mit einem anderen Widerstand $R_3$ verbunden, dieser Widerstand $R_3$ ist auch an den invertierenden Eingang des zweiten Operationsverstärkers **16** und an den Ausgang des zweiten Operationsverstärkers **16** angeschlossen. Am Ausgang des zweiten Operationsverstärkers **16** liegt dann die Spannung $V_{END}$ an.

Die Aufgabe einer solchen Schaltung besteht darin, daß der Verstärker **10** die Eingangsspannung im Anwendungsbeispiel die Oszillatorabstimmspannung $V_{OSZ}$ oder eine davon abhängige Spannung um den Faktor **Y\*** verstärkt. Die Verstärkung ist dabei linear in einer vorgegebenen Schrittweite und Auflösung einstellbar. Die Linearität kann z.B. dadurch erreicht werden, daß dem Widerstand $R_{N1}$ binär abgestufte Werte vom Widerstand $R_{X1}$ zugeschaltet werden. Der variable Widerstand $R_{X1}$ besteht dann tatsächlich aus mehreren parallel geschalteten Widerständen, die je nach Höhe des gewünschten Widerstandswertes dazugeschaltet werden können. Die Verstärkung ergibt sich hierbei durch:

$$Y^* = 1 + \frac{R_{N1}}{R_{X1}}$$

Der Verstärkungsfaktor **Y\*** kann hierbei linear eingestellt werden.

Der andere Operationsverstärker **13** liefert eine linear einstellbare Ausgangsspannung (DA-Wandler). Am Eingang des Verstärkers liegt eine feste Eingangsspannung $V_{EIN}$ an, welche mit den Widerständen $R_{X2}$ und $R_{N2}$ nach dem gleichen oben beschriebenen Prinzip verstärkt werden kann. Somit ergibt sich die Ausgangsspannung $V_{AUS}$ vom Operationsverstärker **13** zu:

$$V_{AUS} = (1 + \frac{R_{N2}}{R_{X2}}) \times V_{EIN}$$

Der dritte Operationsverstärker **16** ist mit den Widerständen $R_3$ und $R_4$ bzw. $R_2$ und $R_1$ als Summierverstärker geschaltet. Ist der Wert von $R_3$ gleich dem Wert von $R_1$ und der Wert von $R_4$ gleich dem Wert von $R2$, dann bildet der Operationsverstärker **16** eine Ausgangsspannung $V_{END}$ mit:

$$V_{END} = ((V_{OSZ} \times Y^*) + V_{AUS}) \times \frac{R_1}{R_2}$$

Der Koeffizient **Y** dieser Schaltung ist damit:

$$Y = Y^* \times \frac{R_1}{R_2}$$

und der additive Koeffizient **X** beträgt:

$$X = V_{AUS} \times \frac{R_1}{R_2}.$$

Die vorab bestimmten **X** und **Y** Koeffizienten können mit dieser Schaltung beliebig eingestellt werden.

Abschließend muß noch erwähnt werden, daß bei der Zuschaltung der binär abgestuften Widerstände, die dann den Wert von $R_{X1}$ bZW. $R_{X2}$ bilden, temperaturbedingte Abweichungen auftreten können, die dadurch zustande kommen, daß die nicht abgebildeten FET Transistoren, die als Schalter für die Zuschaltung der binären Widerstände verwendet werden, temperaturabhängig sind. Dadurch ändert sich der Verstärkungsfaktor über die Temperatur. Um diesen Effekt zu kompensieren wird, werden, wie der gestrichelte Block zeigt, Vorteiler **19**, **20** eingebaut, die ebenfalls einen FET Schalter **21**, **22** beinhalten. Diese kompensieren den oben erwähnten Temperaturgang der als Schalter verwendeten FET-Transistoren bei der binären Abstufung der Widerstände.

**Patentansprüche**

1. Verfahren zum Abgleich eines mehrstufigen selektiven Verstärkers, insbesondere Tuners, welcher einen Oszillatorkreis und einen oder mehrere Abstimmkreise aufweist und bei dem zur Einstellung der Empfangsfrequenz (f) für den Oszillator mittels einer Phasenregelschleife (PLL) eine veränderbare, frequenzbestimmende Abstimmspannung (Vosz) und für die Abstimmkreise veränderbare, frequenzbestimmende Abstimmspannungen (Vvor, Vzwi) zugeführt werden,
   **dadurch gekennzeichnet, daß**
   der Wert der jeweils benötigten Abstimmspannung (Vvor, Vzwi), welche die zum Abgleich erforderliche Frequenz (f) erzeugt, welche den jeweiligen Abstimmkreis auf die gewünschte Empfangsfrequenz (f) einstellt, aus der Abstimmspannung (Vosz) des Oszillators mittels einer mathematischen Beziehung, die die Abhängigkeit der benötigten Abstimmspannung (Vvor, Vzwi) von der Empfangsfrequenz (f) beschreibt, berechnet wird, wobei die mathematische Beziehung bei der Herstellung oder beim Einschalten des Verstärkers, insbesondere Tuners, ermittelt und abgespeichert wird.

2. Verfahren nach Anspruch 1, **dadurch gekennzeichnet, daß** die mathematische Beziehung bei jedem Einschalten des Verstärkers ermittelt wird und bis zum Abschalten des Gerätes abgespeichert ist.

3. Verfahren nach Anspruch 1 oder Anspruch 2, **dadurch gekennzeichnet, daß** die mathematischen Beziehung durch eine Funktion $h(z) = Y \cdot g(z) + X$ beschrieben wird, bei der eine elementare Funktion $g(z)$ mit einem ersten Koeffizienten Y multipliziert wird. und zu der ein weiterer Koeffizient X addiert wird, wobei die elementare Funktion $g(z)$, insbesondere $g(z) = z$, $g(z) = e^z$, bekannt ist und die beiden Koeffizienten X. Y bei der Herstellung oder beim Einschalten des Verstärkers dadurch bestimmt werden indem pro Abstimmkreis die Abstimmspannungswerte $V(A) = h(Z_1)$, $V(B) = h(Z_2)$ für eine höhere und eine niedrigere Empfangsfrequenz $f_H = Z_2$, $f_N = Z_1$ durch ein iteratives Abgleichverfahren ermittelt werden und mit diesen beiden Wertepaaren $V(A)/f_N$, $V(B)/f_H$ die beiden Koeffzienten X, Y berechnet werden.

4. Verfahren nach Patentanspruch 3, **dadurch gekennzeichnet, daß** pro Abstimmkreis die Werte der beiden Koeffizienten X, Y abgespeichert werden und damit die mathematische Beziehung festgelegt wird und daraus alle Abstimmspannungswerte $(V_{VOR}, V_{ZWI})$ berechnet werden.

**Claims**

1. Method of aligning a multi-stage selective amplifier, particularly a tuner, which comprises an oscillator circuit and one or more tuning circuits and in which for setting the receiving frequency (f) a variable, frequency-defining tuning voltage (Vosz) is supplied for the oscillator by means of a phase regulating loop (PLL) and variable, frequency-defining tuning voltages (Vvor, Vzwi) are supplied for the tuning circuits, **characterised in that** the value of the respectively required tuning voltage (Vvor, Vzwi), which produces the frequency (f) which is required for the aligning and sets the respective tuning circuit to the desired receiving frequency (f), is calculated from the tuning voltage (Vosz) of the oscillator by means of a mathematical equation which describes the dependence of the requisite tuning voltage (Vvor, Vzwi) on the receiving frequency (f), wherein the mathematical equation is determined and stored at the time of production or of switching-on of the amplifier, particularly tuner.

2. Method according to claim 1, **characterised in that** the mathematical equation is determined at the time of each switching-on of the amplifier and is stored until switching-off of the apparatus.

3. Method according to claim 1 or 2, **characterised in that** the mathematical equation is described by a function $h(z) = Y \cdot g(Z) + X$, in which an elementary function $g(z)$ is multiplied by a first coefficient Y and added to a further coefficient X, wherein the elementary function $g(z)$, particularly $g(z) = z$, $g(z) = e^z$, is known and the two coefficients X, Y are determined at the time of production or of switching-on of the amplifier in such a manner that the tuning voltage values $V(A) = h(z_1)$, $V(B) = h(z_2)$ for a higher and a lower receiving frequency $f_H = z_2$, $f_N = z_1$ are determined for each tuning circuit by an iterative aligning process and two value pairs $V(A)/f_N$, $V(B)/f_H$ of the two coefficients X, Y are calculated by these.

4.  Method according to patent claim 3, **characterised in that** the values of the two coefficients X, Y are stored for each tuning circuit and thus the mathematical equation is established and all tuning voltage values ($V_{VOR}$, $V_{ZWI}$) are calculated therefrom.

**Revendications**

1.  Procédé pour accorder un amplificateur sélectif à plusieurs étages, en particulier un syntonisateur, présentant un circuit oscillateur et un ou plusieurs circuits accordés, et dans lequel on amène pour ajuster la fréquence de réception (f) pour l'oscillateur au moyen d'une boucle à phase asservie (PLL), une tension de syntonisation (Vosz) modifiable déterminant la fréquence, et pour les circuits accordés des tensions de syntonisation ($V_{VOR}$, $V_{ZWI}$) modifiables déterminant la fréquence, **caractérisé en ce que** la valeur de la tension de syntonisation ($V_{VOR}$, $V_{ZWI}$) respective nécessaire qui génère la fréquence (f) indispensable à l'accord qui ajuste chacun des circuits accordés à la fréquence de réception (f) souhaitée, est calculée à partir de la tension de syntonisation ($V_{OSZ}$) de l'oscillateur au moyen d'une relation mathématique décrivant la dépendance de la tension de syntonisation ($V_{VOR}$, $V_{ZWI}$) nécessaire de la fréquence de réception (f), la relation mathématique étant définie et mémorisée lors de la fabrication ou de la mise en marche de l'amplificateur, en particulier du syntonisateur.

2.  Procédé selon la revendication 1, **caractérisé en ce que** la relation mathématique est définie lors de chaque mise en marche de l'amplificateur et mémorisée jusqu'à l'arrêt de l'appareil.

3.  Procédé selon la revendication 1 ou la revendication 2, **caractérisé en ce que** la relation mathématique est décrite par une fonction h(z) = Y • g(Z) + X, dans laquelle une fonction élémentaire · g(z) est multipliée par un premier coefficient Y et à laquelle on additionne un coefficient supplémentaire X, la fonction élémentaire g(z), en particulier g(z) = z, g(z) = $e^z$ étant connue et les deux coefficients X, Y étant définis lors de la fabrication ou de la mise en marche de l'amplificateur **en ce que** pour chaque circuit accordé les valeurs de tension de syntonisation V(A) = h($z_1$), V(B) = h($z_2$) sont déterminées pour une fréquence de réception plus élevée et plus basse $f_H$ = $z_2$, $f_N$ = $z_1$ par un procédé d'accord itératif et les deux coefficients X, Y calculés à partir de ces deux paires de valeurs V(A) /$f_N$, V(B)/$f_H$.

4.  Procédé selon la revendication 3, **caractérisé en ce que** les valeurs des deux coefficients X, Y sont mémorisées pour chaque circuit de syntonisation et qu'ainsi la relation mathématique est définie et toutes les valeurs de syntonisation ($V_{VOR}$, $V_{ZWI}$) calculées à partir d'elle.

FIG.1

FIG.2a

FIG. 2b

FIG. 3a

FIG. 3b

FIG.4